# EUROPÄISCHE PATENTSCHRIFT

(11) **EP 3 462 194 B1**
(45) Veröffentlichungstag und Bekanntmachung des Hinweises auf die Patenterteilung: **03.07.2024**
(21) Anmeldenummer: 18191404.5
(22) Anmeldetag: 29.08.2018
(51) Int. Cl.: G01R 31/08

(54) **VERFAHREN UND SCHALTUNGSANORDNUNGEN ZUR LOKALISIERUNG EINES FEHLERORTES AUF EINER ELEKTRISCHEN LEITUNG AUF BASIS DER ZEITBEREICHSREFLEKTOMETRIE**
METHOD AND CIRCUIT ARRANGEMENTS FOR LOCATING AN ERROR LOCATION ON AN ELECTRICAL LINE BASED ON TIME-DOMAIN REFLECTOMETRY
PROCÉDÉ ET AGENCEMENT DE CIRCUIT DESTINÉE À LA LOCALISATION D'UN EMPLACEMENT DÉFECTUEUX SUR UNE LIGNE ÉLECTRIQUE À BASE D'UNE RÉFLECTOMÉTRIE À DIMENSION TEMPORELLE

(30) Priorität: 21.09.2017 DE 102017216771
(43) Veröffentlichungstag der Anmeldung: 03.04.2019
(73) Patentinhaber: Bender GmbH & Co. KG, 35305 Grünberg (DE)
(72) Erfinder: BRÖCKMANN, Eckhard, 35396 Gießen (DE)
(74) Vertreter: advotec.

(56) Entgegenhaltungen:
- WO-A2-2004/070398
- DE-A1-102015 122 128
- DE-T2- 60 103 779
- US-A1- 2003 125 893
- US-A1- 2005 289 408
- US-A1- 2006 039 322
- US-A1- 2007 194 796

## Beschreibung

Die Erfindung betrifft Verfahren und Schaltungsanordnungen zur Lokalisierung eines Fehlerortes auf einer elektrischen Leitung auf Basis der Zeitbereichsreflektometrie.

Die vorliegend beschriebenen Verfahren und Schaltungsanordnungen dienen zur Ortung einer Störstelle, insbesondere eines Isolationsfehlers, auf elektrischen Leitungen unter Anwendung von Verfahren der Zeitbereichsreflektometrie.

Bekannte Methoden der Zeitbereichsreflektometrie beruhen darauf, einen Messimpuls (Sendesignal) in die Leitung einzuspeisen und aufgrund von Leitungsstörungen reflektierte Impulse (Reflexionssignal) zu empfangen und hinsichtlich ihrer Laufzeit und Amplitude auszuwerten, um eine Fehlstelle auf der Leitung zu lokalisieren.

Jede Störstelle in Form einer Änderung des auf einer homogenen Leitung konstanten, längenbezogenen elektrischen Widerstands stellt eine Diskontinuität des Leitungswellenwiderstands, also eine Impedanzfehlanpassung dar.

An der Stelle der Diskontinuität (Fehlerort) wird ein Anteil des eingespeisten, auf die Störstelle zulaufenden Messimpulses reflektiert und ein zurücklaufendes Reflexionssignal erzeugt, welches als quantitatives und qualitatives Maß für die Existenz einer Störstelle auf der Leitung erfasst werden kann. Insbesondere kann mittels Korrelationsberechnungen und Bestimmung der Signallaufzeit in Kenntnis der Ausbreitungsgeschwindigkeit die Entfernung des Fehlerortes bestimmt werden.

Als Nachteil bekannter auf der Zeitbereichsreflektometrie beruhender Konzepte erweist sich, dass die Einspeisung des Sendesignals oftmals mit einer der Netzimpedanz der elektrischen Leitung (Schleifenimpedanz zwischen zwei Leitern einer elektrischen Leitung) unangepassten Amplitude erfolgt.

Eine hohe Verstärkung des Sendesignals erbringt zwar den Vorteil eines guten Signal-Rausch-Verhältnisses, kann aber im Regelbetrieb der elektrischen Anlage zu einer starken EMV-Gesamtbelastung (elektromagnetische Verträglichkeit) führen. Zur Einhaltung der EMV-Grenzwerte ist dann eine niedrige Verstärkung des Sendesignals erforderlich, was mit einem geringeren Signal-Rausch-Verhältnis einhergeht.

Zudem kann der Netzbetreiber gezwungen sein, die elektrische Anlage zum Zweck der Fehlerortung außer Betrieb zu nehmen, da im Dauerbetrieb des Netzes erwartungsgemäß bei Zeitbereichsreflektometrie-Verfahren eine längere Messzeit erforderlich ist, um betriebsbedingte, durch Stromverbraucher verursachte Störeinflüsse mittels Signal-Mittelung zu eliminieren.

Weiterhin verwenden bekannte Verfahren Impulsfolgen mit guten Korrelationseigenschaften, d. h. einem ausgeprägten Maximum ihrer Autokorrelationsfunktion (AKF) (Peak-förmige Autokorrelationsfunktion). Jedoch weisen diese Signale naturgemäß aufgrund signaltheoretischer Prinzipien ein breites Spektrum auf. Diese spektrale Spreizung belastet die Leitung breitbandig mit EMV-Störungen.

Ein weiterer Nachteil ist, dass die Stoffkonstanten elektrischer Leitungen eine Frequenzabhängigkeit aufweisen (Dispersion), was insbesondere bei breitbandigen Signalen zu Laufzeitverzerrungen führt. Aufgrund der Verschmierung der übertragenen Signalimpulse entsteht daher eine Unsicherheit bei der Laufzeitbestimmung.

Weiterhin beruhen bekannte Konzepte der Zeitbereichsreflektometrie auf der Bildung der Kreuzkorrelation zwischen der unbearbeiteten, in dem Signalgenerator erzeugten Pseudozufalls-Impulsfolge (PN-Folge oder Maximalfolge) und dem empfangenen Reflexionssignal. Systematische Effekte der Impulsverformung wie die Impulsverformung durch die senderseitige Netzankopplung, durch die komplexwertige Netzimpedanz, durch die empfängerseitige Netzankopplung und durch den Tiefpass-Effekt der Leitung werden dabei nicht berücksichtigt und können zu Fehlbewertungen führen.

Die Offenlegungsschrift WO 2004/070398 A2 zeigt beispielsweise ein Verfahren zur Lokalisierung von Störstellen auf einer Signalleitung, welche ein operatives Signal führt. Ausgehend von einer Pseudo-Noise-Folge wird ein oder werden mehrere Reference-Spread-Spectrum-Signale auf die zu untersuchende Leitung gegeben und in einer Korrelationsberechnung zwischen dem Reference-Spread-Spectrum-Signal und dem empfangenen Reflektionssignal kann die Übertragungscharakteristik der Signalleitung ermittelt werden.

Die US- Offenlegungsschriften US 2005/0289408 A1 undUS 2006/039322 A1 zeigen ebenfalls ein auf dem Verfahren der Zeitbereichsreflektometrie beruhendes System zur Charakterisierung eines Übertragungsweges, wobei die Korrelation einer erzeugten PN-Sequenz mit dem reflektierten Signal mit Überabtastung erfolgt.

Die weitere US-Offenlegungsschrift US 2003/125893 A1 beschreibt ein auf dem Verfahren der Frequenzbereichsreflektometrie beruhendes Testsystem zur Bestimmung der Übertragungseigenschaften einer elektrischen Leitung, wobei das empfangene reflektierte Signal zur Weiterverarbeitung mit unterschiedlicher Verstärkung weiteregeleitet werden kann.

Der vorliegenden Erfindung liegt somit die Aufgabe zu Grunde, auf Basis der Zeitbereichsreflektometrie ein Verfahren und eine Vorrichtung zu entwerfen, die unter besonderer Berücksichtigung der elektromagnetischen Verträglichkeit und der Ausbreitungsbedingungen auf elektrischen Leitungen eine zuverlässige Lokalisierung eines Fehlerortes auf der elektrischen Leitung ermöglichen.

Diese Aufgabe wird gelöst durch Verfahren zur Lokalisierung eines Fehlerortes auf einer elektrischen Leitung nach den unabhängigen Ansprüchen 1 und 5.

In Umsetzung der erfindungsgemäßen Verfahren wird die Aufgabe weiter gelöst durch Schaltungsanordnungen zur Lokalisierung eines Fehlerortes auf einer elektrischen Leitung nach den Ansprüchen 6 und 9.

Dazu wird zunächst in einem Signalgenerator eine Pseudozufalls-Impulsfolge der Länge M erzeugt. Diese Impulsfolge stellt ein zeitbegrenztes, zeitkontinuierliches Signal dar und setzt sich aus einer Folge von M Rechteck-Impulsen zusammen, die mit einer binärwertigen Pseudozufalls-Codefolge der Länge M bewertet sind. Eine derartige Codefolge führt (im Zeitbereich) zu Korrelationseigenschaften der Impulsfolge, die sich durch eine gewünschte Peak-förmige Autokorrelationsfunktion auszeichnen. Allerdings weist eine so konstruierte Impulsfolge auch eine spektrale Spreizung auf, die zu breitbandigen EMV-Störeinflüssen auf der Leitung führen kann.

Um diese Störungen abzuschwächen, wird zur Einspeisung in die elektrische Leitung aus der Pseudozufalls-Impulsfolge durch Begrenzen des Frequenzspektrums ein ideales Sendesignal erzeugt - weitere Impulsverformungen durch Störeinflüsse auf der Übertragungsstrecke bleiben an dieser Stelle noch unberücksichtigt.

Ein weiterer Vorteil der Bandbegrenzung besteht in der geringeren Anforderung an die Bandbreite von Sende- und Empfangs-Verstärkern.

Das bandbegrenzte ideale Sendesignal kann ein schmalbandiges Tiefpass-Signal oder ein schmalbandiges Bandpass-Signal sein.

Die Begrenzung des Frequenzspektrums erfolgt vorzugsweise softwaretechnisch in einer digitalen Filtereinheit.

In einem nächsten Schritt wird das ideale Sendesignal von einem Sendeverstärker mit einer variabel voreinstellbaren Sendeverstärkung über eine Sende-Ankopplungsschaltung auf die elektrische Leitung geschaltet.

Der Vorteil dieser aktiven Sende-Ankopplung mit variabel voreinstellbarer Sendeverstärkung liegt insbesondere darin, dass eine Anpassung an die jeweils herrschende Netzimpedanz vorgenommen werden kann mit dem Ziel, die leitungsgebundene Störbelastung im Sinne der elektromagnetischen Verträglichkeit (EMV) in Grenzen zu halten.

Das ideale Sendesignal unterliegt bei der Einspeisung und Übertragung einem Transformationsprozess, der vornehmlich durch die Impulsverformungen in der Sende-Ankopplungsschaltung, in der komplexwertigen Netzimpedanz und durch die Impulsverformung in einer Empfangs-Ankopplungsschaltung charakterisiert ist.

Eine grundlegende Idee der vorliegenden Erfindung beruht nun darauf, nicht die Pseudozufalls-Impulsfolge als Referenz für eine Korrelation mit dem empfangenen Reflexionssignal zu verwenden, sondern ein aus dem idealen Sendesignal abgeleitetes reales Sendesignal, welches die Impulsverformungen am Ort der Einspeisung bereits berücksichtigt.

Dazu wird während des Sendens des idealen Sendesignals das durch die Impulsverformungen veränderte ideale Sendesignal als reales Sendesignal über die aktive Empfangs-Ankopplungsschaltung mit einer ersten einstellbaren Empfangsverstärkung empfangen und aufgezeichnet.

Die Korrelation des Reflexionssignals erfolgt dann mit dem bereits verformten Sendesignal statt mit der üblicherweise verwendeten Pseudozufalls-Impulsfolge. Da die Korrelation ein Maß für die Ähnlichkeit zweier Signale darstellt, führt die Verwendung des realen Sendesignals zu einer Kreuzkorrelationsfunktion mit einem ausgeprägteren, eindeutigen Maximalwert und damit zu einer zuverlässigeren Auswertung.

Der Empfang des realen Sendesignals während der Aussendung des idealen Sendesignals erfolgt mit einer ersten einstellbaren Empfangsverstärkung, die derart bemessen ist, dass keine Übersteuerung in einem Empfangsverstärker auftritt, da das empfangene reale Sendesignal im Gegensatz zu dem empfangenen Reflexionssignal eine Amplitude aufweist, die nicht infolge einer Leitungsdämpfung abgeschwächt ist.

Nach dem Empfang des realen Sendesignals erfolgt in dem Empfangsverstärker ein Umschalten der ersten einstellbaren Empfangsverstärkung auf eine zweite einstellbare Empfangsverstärkung, die größer als die erste einstellbare Empfangsverstärkung ist. Damit wird dem später eintreffenden, abgeschwächten Reflexionssignal Rechnung getragen. Der Empfangsverstärker nimmt die Umschaltung der Verstärkung unmittelbar nach dem Senden des idealen Sendesignals in einer sehr kurzen Umschaltphase vor.

Anschließend wird in einem Korrelationsempfänger die Berechnung der Kreuzkorrelationsfunktion zwischen dem empfangenen realen Sendesignal und dem empfangenen Reflexionssignal durchgeführt.

In einer Auswerteeinheit erfolgt eine Bestimmung des Fehlerortes auf der elektrischen Leitung durch Auswerten der Kreuzkorrelationsfunktion mittels einer Signal-Laufzeitbetrachtung.

Alternativ zu der Verwendung von Pseudozufalls-Impulsfolgen wird die Impulssequenz aus zwei verschiedenen aufeinanderfolgenden Teilfolgen zusammengesetzt, die aus zueinander komplementären Codefolgen gebildet werden, wobei zur Bestimmung des Fehlerortes zwei aufeinanderfolgende, aus den jeweiligen Teilfolgen berechnete Korrelationsfunktionen addiert werden.

Die Besonderheit komplementärer Codes besteht darin, dass stets zwei verschiedene Codes auftreten, die paarweise abwechselnd gesendet werden. Die Autokorrelationsfunktion der einzelnen Codes enthält Nebenzipfel, die Summe der Autokorrelationsfunktionen beider Codes ist jedoch frei von Nebenzipfeln, was für eine Erkennung des Maximums bei ungünstigem Signal-Rausch-Verhältnis vorteilhaft ist.

Weiterhin erfolgt das Begrenzen des Frequenzspektrums der Pseudozufalls-Impulsfolge im Spektralbereich durch Nullsetzen von Werten eines Fourier-Spektrums oberhalb einer einstellbaren Grenzfrequenz.

Alternativ kann das Begrenzen des Frequenzspektrums der Pseudozufalls-Impulsfolge im Zeitbereich durch eine Tiefpassfilterung mit einer einstellbaren Grenzfrequenz erfolgen.

Die der Erfindung zugrundeliegende Aufgabe wird weiter gelöst durch ein zweites Verfahren, welches die folgenden Verfahrensschritte umfasst: Erzeugen eines zeitbegrenzten idealen Sendesignals aus einem harmonischen Signal mit Gauß-förmiger Hüllkurve, Senden des idealen Sendesignals mit einer variabel voreinstellbaren Sendeverstärkung, Empfangen und Aufzeichnen eines realen Sendesignals mit einer ersten einstellbaren Empfangsverstärkung während des Sendens des idealen Sendesignals, Umschalten der ersten einstellbaren Empfangsverstärkung auf eine zweite einstellbare Empfangsverstärkung, die größer als die erste einstellbare Empfangsverstärkung ist, Empfangen eines Reflexionssignals mit der zweiten einstellbaren Empfangsverstärkung, Berechnen einer Kreuzkorrelationsfunktion zwischen dem empfangenen realen Sendesignal und dem empfangenen Reflexionssignal und Bestimmen des Fehlerortes auf der elektrischen Leitung durch Auswerten der Kreuzkorrelationsfunktion mittels einer Laufzeitbetrachtung.

Im Unterschied zum ersten Verfahren, bei dem die unvermeidbare spektrale Spreizung idealer Sendesignale mit Pseudozufalls-Impulsfolgen durch anschließende Spektralformung mit Tiefpassfilterung eingeschränkt wird, kommt in diesem zweiten Verfahren ein harmonisches Signal mit Gauß-förmiger Hüllkurve (Bandpass-Signal) als ideales Sendesignal zum Einsatz.

Auf Leitungen mit Tiefpass-Effekt kann es ein Vorteil bedeuten, Impulse mit einem sehr schmalbandigen Spektrum zu verwenden, bei denen die Gruppenlaufzeit und die Leitungsdämpfung im Wesentlichen nur bei einer Frequenz bekannt sein müssen. Harmonische Signale mit Gauß-förmiger Hüllkurve zeigen diese Eigenschaft, da deren Spektrum infolge der Energiekonzentration im Frequenzbereich stark eingeschnürt ist und in Gegensatz zu den zuvor beschriebenen Tiefpass-Signalformen nicht bis nahe zu 0 Hz reicht. Allerdings wird das schmale Spektrum mit einer großen Unschärfe der Autokorrelationsfunktion, d. h. einer stark oszillierenden Autokorrelationsfunktion erkauft.

Die weiteren Verfahrensschritte des zweiten Verfahrens, nämlich Senden des idealen Sendesignals, Empfangen und Aufzeichnen eines realen Sendesignals, Umschalten der einstellbaren Empfangsverstärkung, Empfangen eines Reflexionssignals, Berechnen einer Kreuzkorrelationsfunktion und Bestimmen des Fehlerortes entsprechen denen des ersten Verfahrens.

Zur Durchführung des zweiten Verfahrens wird die Aufgabe durch eine zweite Schaltungsanordnung zur Lokalisierung eines Fehlerortes auf einer elektrischen Leitung, welche gekennzeichnet ist durch einen Signalgenerator zum Erzeugen eines zeitbegrenzten idealen Sendesignals aus einem harmonischen Signal mit Gauß-förmiger Hüllkurve, einen Sendeverstärker mit einer variabel voreinstellbaren und umschaltbaren Sendeverstärkung und eine Sende-Ankopplungsschaltung, einen Empfangsverstärker mit einer variabel voreinstellbaren Empfangsverstärkung und eine Empfangs-Ankopplungsschaltung, einen Korrelationsempfänger zum Berechnen einer Kreuzkorrelationsfunktion zwischen dem empfangenen realen Sendesignal und dem empfangenen Reflexionssignal und eine Auswerteeinheit zum Bestimmen des Fehlerortes auf der elektrischen Leitung.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:
- **Fig. 1:**: ein funktionales Blockdiagramm der erfindungsgemäßen Schaltungsanordnung,
- **Fig. 2a:**: eine Pseudozufalls-Impulsfolge mit Spektrum und Autokorrelationsfunktion auf Basis einer Maximalfolge,
- **Fig. 2b:**: die Pseudozufalls-Impulsfolge aus Fig. 2a mit Bandbegrenzung im Frequenzbereich als ideales Sendesignal,
- **Fig. 2c:**: die Pseudozufalls-Impulsfolge aus Fig. 2a mit Bandbegrenzung im Zeitbereich als ideales Sendesignal,
- **Fig. 3a:**: eine Pseudozufalls-Impulsfolge mit Autokorrelationsfunktion auf Basis komplementärer Codes,
- **Fig. 3b:**: die Pseudozufalls-Impulsfolge aus Fig. 3a mit Bandbegrenzung im Frequenzbereich als ideales Sendesignal,
- **Fig. 4:**: ein harmonisches Signal mit Gauß-förmiger Hüllkurve als ideales Sendesignal und
- **Fig. 5:**: ein reales Sendesignal.

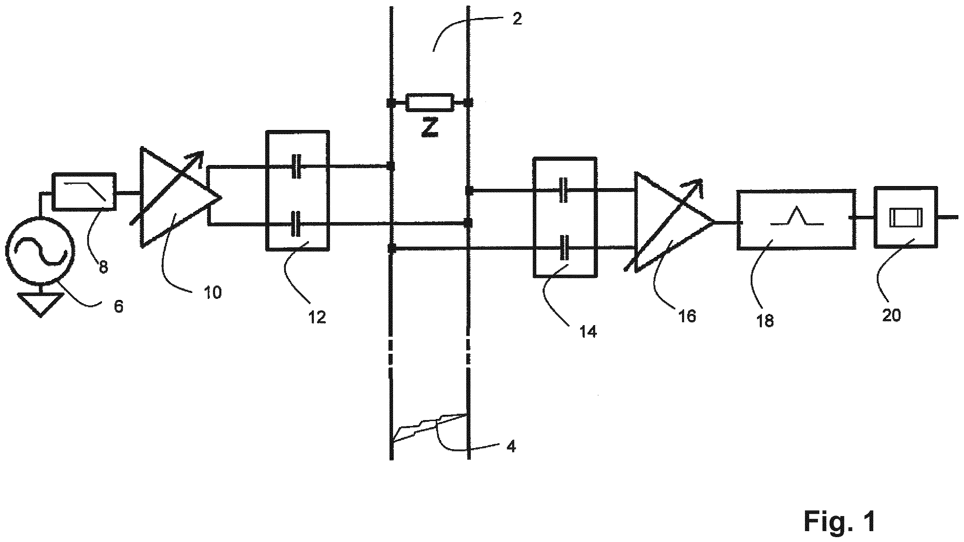

**Fig. 1** zeigt ein funktionales Blockdiagramm der erfindungsgemäßen Schaltungsanordnung zur Erkennung eines Fehlerortes 4 auf einer elektrischen Leitung 2.

Sendeseitig weist die Schaltungsanordnung einen Signalgenerator 6 zur Erzeugung einer Pseudozufalls-Impulsfolge der Länge M auf, wobei der Signalgenerator 6 einen Codegenerator zur Erzeugung einer binärwertigen Pseudozufalls-Codefolge sowie zur Bildung einer zeitkontinuierlichen Signalform (Wellenform-Signal) aus der binärwertigen Pseudozufalls-Codefolge einen Rechteck-Impulsgenerator umfasst.

Das Frequenzspektrum dieses Wellenform-Signals wird in einer Filtereinheit 8 begrenzt, sodass aus dem theoretisch unendlich ausgedehnten Spektrum der Pseudozufalls-Impulsfolge an dem Ausgang der Filtereinheit 8 ein schmalbandiges, ideales Sendesignal entsteht.

Im Falle der Verwendung eines harmonischen Signals mit Gauß-förmiger Hüllkurve wird das harmonische Signal in dem Signalgenerator 6 bereits als ideales Sendesignal erzeugt und die Bandbegrenzung durch die Filtereinheit 8 entfällt.

Das ideale Sendesignal wird über einen Sendeverstärker 10 mit einer variabel voreinstellbaren Sendeverstärkung und eine Sende-Ankopplungsschaltung 12, die als Hochpass ausgeführt ist, in die elektrische Leitung 2 eingekoppelt.

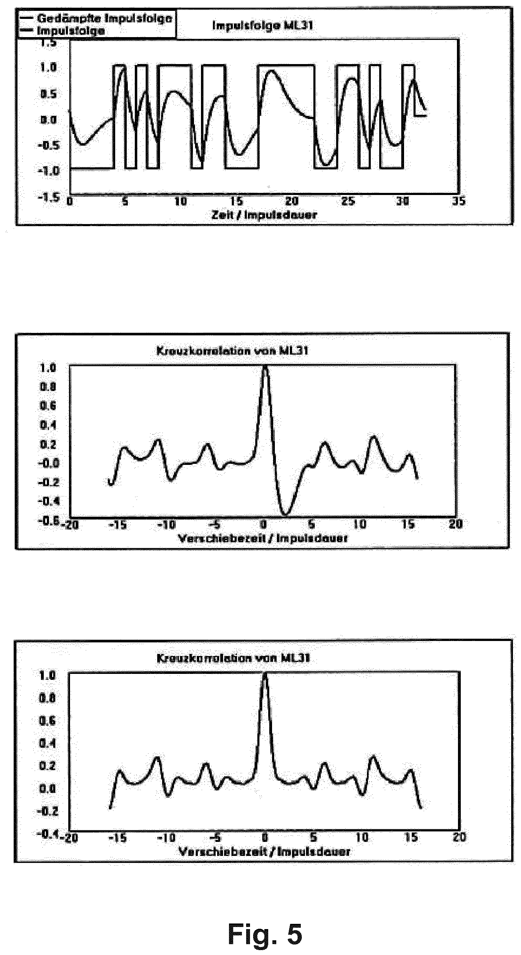

Die elektrische Leitung 2 wird durch eine Stromversorgungseinrichtung (nicht dargestellt) mit der Netzimpedanz Z versorgt. Die Netzimpedanz kann stark frequenzabhängig und zeitlich variabel sein und hat einen Einfluss auf die Größe und die Form des realen Sendesignals, siehe Fig. 5.

Empfangsseitig wird das reflektierte Signal oder, erfindungsgemäß während des Sendens des idealen Sendesignals, auch dieses Sendesignal als reales Sendesignal über eine als Hochpass ausgeführte Empfangs-Ankopplungsschaltung 14 und einen Empfangsverstärker 16 mit einer variabel voreinstellbaren und umschaltbaren Empfangsverstärkung empfangen. Das empfangene reale Sendesignal wird dabei für die Verwendung zur Korrelationsberechnung in einem Datenspeicher aufgezeichnet.

In einem Korrelationsempfänger 18 erfolgt die Berechnung der Kreuzkorrelationsfunktion zwischen dem empfangenen realen Sendesignal und dem empfangenen Reflexionssignal.

Eine Auswerteeinheit 20 übernimmt die Auswertung der Kreuzkorrelationsfunktion mittels einer Signal-Laufzeitbetrachtung zum Bestimmen des Fehlerortes auf der elektrischen Leitung.

Die Realisierung der Funktionsblöcke, insbesondere des Signalgenerators 6, der Filtereinheit 8, des Korrelationsempfängers 18 und der Auswerteeinheit 20 erfolgt entweder als Software-Implementierung auf einem Mikro- oder Signalprozessor oder in digitalen Funktionsbausteinen als programmierte Hardware wie z.B. in FPGAs oder ASICs.

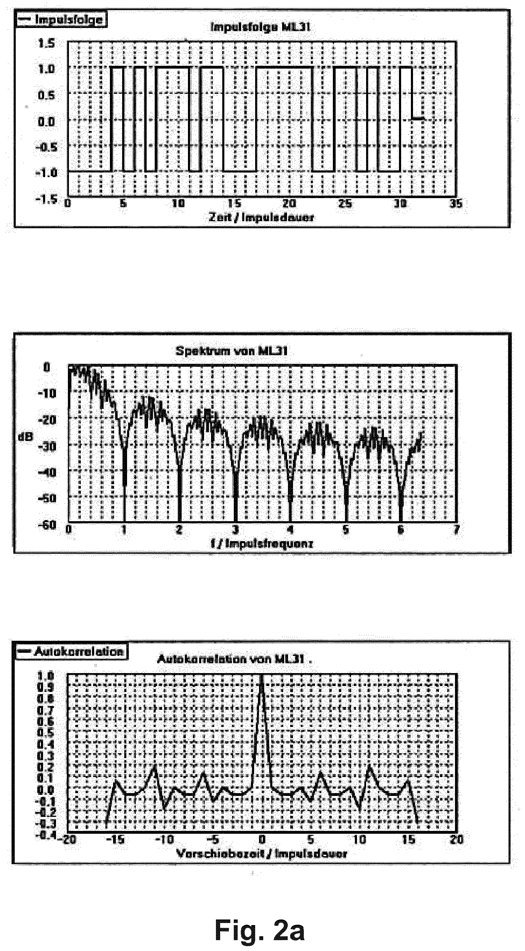

In **Fig.2a** ist eine Pseudozufalls-Impulsfolge ausgehend von einer Maximalfolge der Länge M=31 im Zeitbereich sowie deren Spektrum und deren Autokorrelationsfunktion dargestellt. Die Pseudozufalls-Impulsfolge besitzt zwar ein ausgedehntes breitbandiges Spektrum, weist aber eine vorteilhafte Autokorrelationseigenschaft mit einem ausgeprägten schmalen Maximum auf.

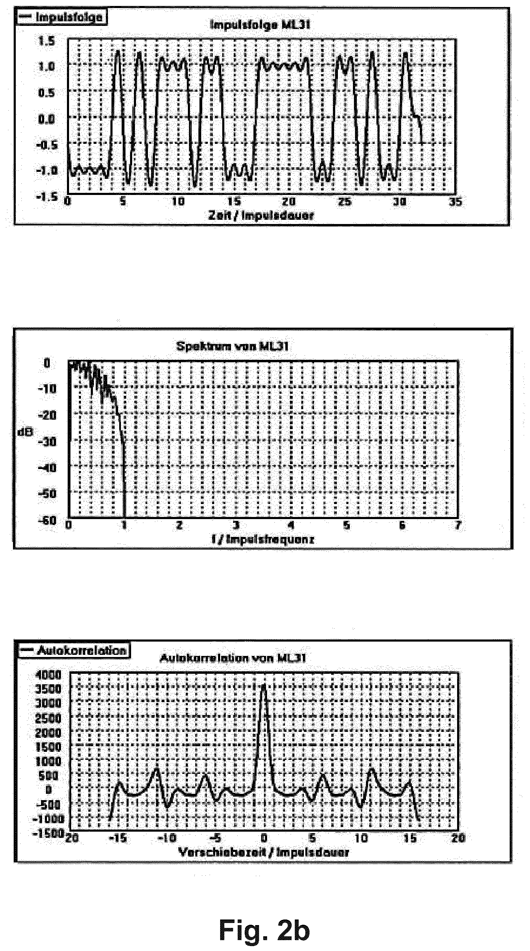

**Fig. 2b** zeigt als ideales Sendesignal die Pseudozufalls-Impulsfolge aus Fig. 2a mit Bandbegrenzung im Frequenzbereich. Die Bandbegrenzung erfolgt durch Nullsetzen von Werten des Fourier-Spektrums oberhalb einer einstellbaren Grenzfrequenz. Als Grenzfrequenz wurde die Impulsfrequenz gewählt, die dem reziproken Wert einer Symboldauer entspricht, wobei sich die Symboldauer aus der Dauer der M Einzelimpulse ergibt.

Im Ergebnis zeigt sich, dass die scharfe Bandbegrenzung zwar zu Überschwingungen im Zeitbereich führt, sich aber nur in einer unwesentlichen Verbreiterung des Maximalwertes der Autokorrelationsfunktion auswirkt.

Somit ist eine zuverlässige Lokalisierung des Fehlerortes auf der elektrischen Leitung auch mit einem schmalbandigen, EMV-gerechten, an die Ausbreitungsbedingungen auf der elektrischen Leitung angepassten und einfach zu verstärkenden Sendesignal möglich.

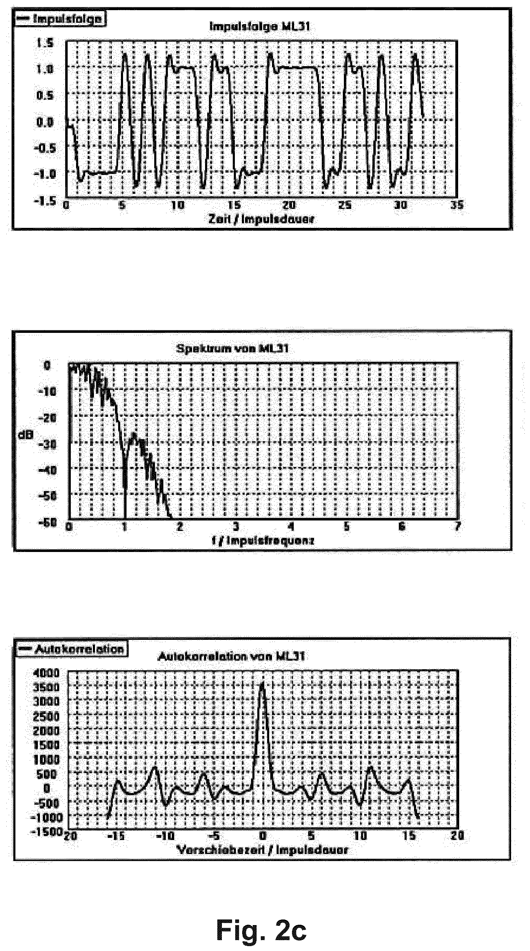

Einen ähnlich positiven Effekt bewirkt die in **Fig. 2c** dargestellte Pseudozufalls-Impulsfolge aus Fig. 2a mit Bandbegrenzung durch eine Tiefpassfilterung mit einer einstellbaren Grenzfrequenz im Zeitbereich.

Auch hier entspricht die Grenzfrequenz ungefähr dem reziproken Wert einer Symboldauer.

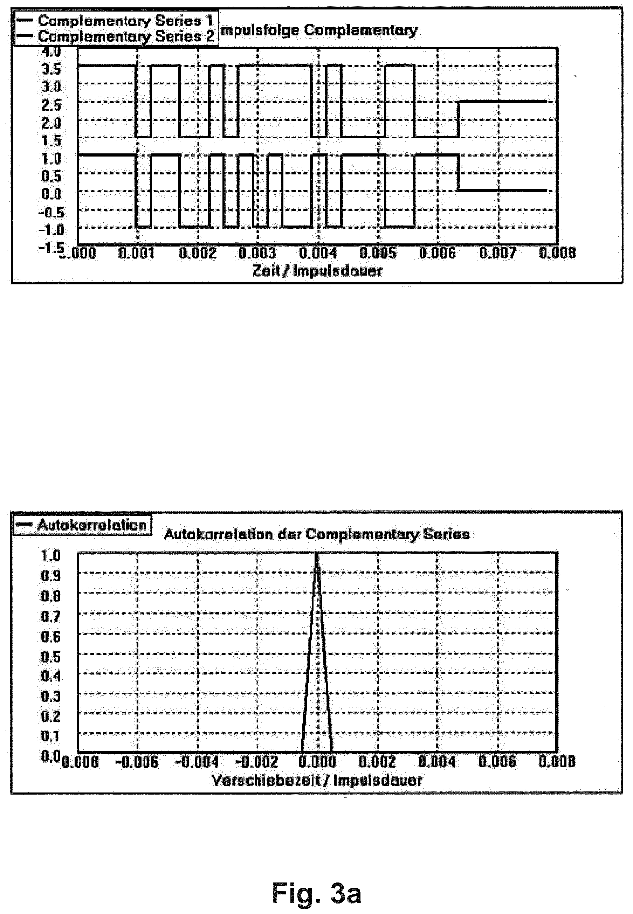

In **Fig. 3a** ist eine Pseudozufalls-Impulsfolge mit Autokorrelationsfunktion auf Basis von zwei zueinander komplementären Codes dargestellt. Die gezeigte Autokorrelationsfunktion ergibt sich aus der Summe der zeitlich aufeinanderfolgend ermittelten Autokorrelationsfunktionen der jeweiligen Pseudozufalls-Impulsfolge (Teilfolge). Zur Bestimmung des Fehlerortes werden somit zunächst die Kreuzkorrelationsfunktion des Reflexionssignals mit der zuerst gesendeten Pseudozufalls-Impulsfolge (auf Basis einer ersten Codefolge), dann die Kreuzkorrelationsfunktion des Reflexionssignals mit der darauffolgend gesendeten Pseudozufalls-Impulsfolge (auf Basis einer zweiten Codefolge) gebildet und anschließend beide Kreuzkorrelationsfunktionen addiert.

Im Ergebnis zeigt sich eine (Summen-) Korrelationsfunktion, die frei von Nebenzipfeln ist und somit die Bestimmung des Fehlerortes zuverlässig gewährleistet.

Die Anwendung komplementärer Codes kann unter praktischen Gesichtspunkten wie EMV und Anpassung an die Ausbreitungsbedingungen auf der Leitung noch dahingehend modifiziert werden, dass wie zuvor für die Maximalfolgen beschriebene Maßnahmen zur Bandbegrenzung getroffen werden um ein ideales Sendesignal zu erzeugen.

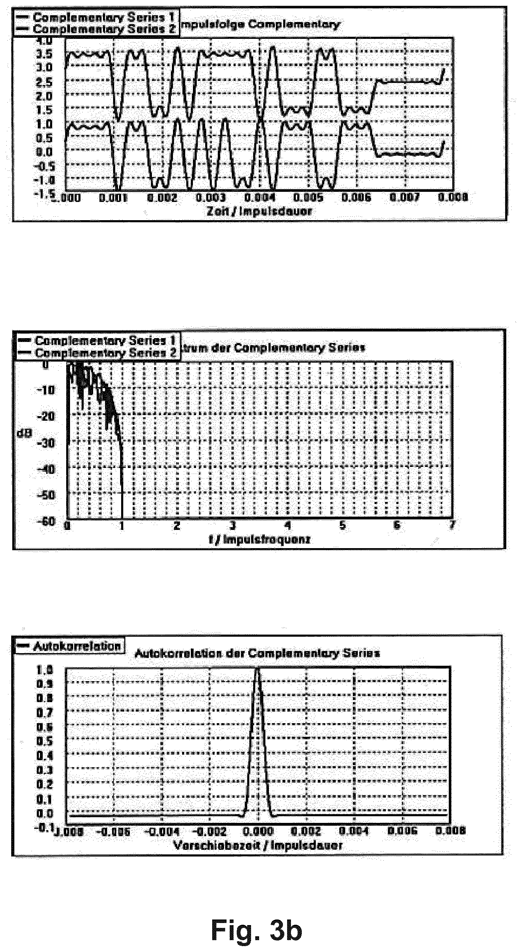

**Fig. 3b** zeigt beispielhaft die Bandbegrenzung durch Nullsetzen von Werten des Fourier-Spektrums oberhalb einer einstellbaren Grenzfrequenz. Es ist nur eine geringfügige Verbreiterung des Maximalwertes der Autokorrelationsfunktion erkennbar.

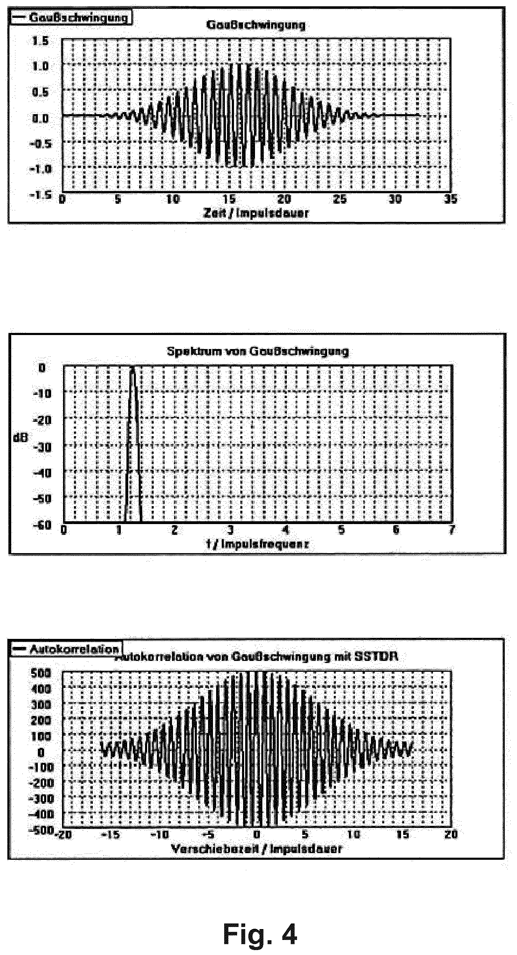

**In** **Fig. 4** ist ein harmonisches Signal mit Gauß-förmiger Hüllkurve gezeigt. Dieses Signal ist ein schmalbandiges Bandpass-Signal wie die spektrale Darstellung zeigt und erfüllt damit die Anforderungen hinsichtlich der EMV und Anpassung an die Ausbreitungsbedingungen auf der Leitung. Eine damit verbundene stark oszillierende Autokorrelationsfunktion kann mit einem Hüllkurvenempfänger zur Detektion des Maximums in einfacher Weise ausgewertet werden.

**Fig. 5** zeigt ein reales Sendesignal (gerundete Signalform in erstem Diagramm) im Vergleich zu einer Pseudozufalls-Impulsfolge (Rechteck-Signalform in erstem Diagramm) und die sich ergebenden Kreuzkorrelationsfunktionen des Reflexionssignals mit dem idealen Sendesignal (zweites Diagramm) bzw. mit dem realen Sendesignal (drittes Diagramm). Es zeigen sich günstigere Korrelationseigenschaften, die sich in einem eindeutigen und symmetrischen Maximalwert der Kreuzkorrelationsfunktion äußern, wenn das aus dem idealen Sendesignal abgeleitete reale Sendesignal anstelle des idealen Sendesignals zur Korrelation verwendet wird. Dies liegt darin begründet, dass das reale Sendesignal bereits die Impulsverformungen in der Sende-Ankopplungsschaltung, infolge der komplexwertigen Netzimpedanz und durch die Impulsverformung in der Empfangs-Ankopplungsschaltung bereits berücksichtigt und damit dem Reflexionssignal ähnlicher ist.

## Patentansprüche

1. Verfahren zur Lokalisierung eines Fehlerortes (4) auf einer elektrischen Leitung (2) nach einem Verfahren der Zeitbereichsreflektometrie, umfassend die Verfahrensschritte:
Erzeugen einer Pseudozufalls-Impulsfolge der Länge M mittels eines Signalgenerators (6),
Erzeugen eines idealen Sendesignals aus der Pseudozufalls-Impulsfolge durch Begrenzen eines Frequenzspektrums der Pseudozufalls-Impulsfolge mittels einer Filtereinheit (8),
Senden des idealen Sendesignals mit einer variabel voreinstellbaren Sendeverstärkung mittels eines Sendeverstärkers (10) und einer Sende-Ankopplungsschaltung (12),
Empfangen und Aufzeichnen eines realen Sendesignals mit einer ersten einstellbaren Empfangsverstärkung während des Sendens des idealen Sendesignals mittels einer Empfangs-Ankopplungsschaltung (14) und eines Empfangsverstärkers (16),
Umschalten der ersten einstellbaren Empfangsverstärkung des Empfangsverstärkers (16) auf eine zweite einstellbare Empfangsverstärkung des Empfangsverstärkers (16), die größer als die erste einstellbare Empfangsverstärkung ist,
Empfangen eines Reflexionssignals mit der zweiten einstellbaren Empfangsverstärkung mittels der Empfangs-Ankopplungsschaltung (14) und des Empfangsverstärkers (16),
Berechnen einer Kreuzkorrelationsfunktion zwischen dem empfangenen realen Sendesignal und dem empfangenen Reflexionssignal mittels eines Korrelationsempfängers (18),
Bestimmen des Fehlerortes (4) auf der elektrischen Leitung (2) durch Auswerten der Kreuzkorrelationsfunktion mittels einer Signal-Laufzeitbetrachtung in einer Auswerteeinheit (20).

2. Verfahren nach Anspruch 1,
**dadurch gekennzeichnet,**
**dass** die Pseudozufalls-Impulsfolge aus zwei aufeinanderfolgenden Teilfolgen erzeugt wird, die aus zueinander komplementären Codefolgen gebildet werden und dass zur Bestimmung des Fehlerortes zwei aufeinanderfolgende, aus den jeweiligen Teilfolgen berechnete Korrelationsfunktionen addiert werden.

3. Verfahren nach Anspruch 1 oder 2,
**dadurch gekennzeichnet,**
**dass** das Begrenzen (8) des Frequenzspektrums der Pseudozufalls-Impulsfolge im Spektralbereich durch Nullsetzen von Werten eines Fourier-Spektrums oberhalb einer einstellbaren Grenzfrequenz erfolgt.

4. Verfahren nach Anspruch 1 oder 2,
**dadurch gekennzeichnet,**
**dass** das Begrenzen (8) des Frequenzspektrums der Pseudozufalls-Impulsfolge im Zeitbereich durch eine Tiefpassfilterung mit einer einstellbaren Grenzfrequenz erfolgt.

5. Verfahren zur Lokalisierung eines Fehlerortes (4) auf einer elektrischen Leitung (2) nach einem Verfahren der Zeitbereichsreflektometrie, umfassend die Verfahrensschritte:
Erzeugen (6) eines zeitbegrenzten idealen Sendesignals aus einem harmonischen Signal mit Gauß-förmiger Hüllkurve mittels eines Signalgenerators (6),
Senden des idealen Sendesignals mit einer variabel voreinstellbaren Sendeverstärkung mittels eines Sendeverstärkers (10) und einer Sende-Ankopplungsschaltung (12),
Empfangen und Aufzeichnen eines realen Sendesignals mit einer ersten einstellbaren Empfangsverstärkung während des Sendens des idealen Sendesignals mittels einer Empfangs-Ankopplungsschaltung (14) und eines Empfangsverstärkers (16),
Umschalten der ersten einstellbaren Empfangsverstärkung des Empfangsverstärkers (16) auf eine zweite einstellbare Empfangsverstärkung des Empfangsverstärkers (16), die größer als die erste einstellbare Empfangsverstärkung ist,
Empfangen eines Reflexionssignals mit der zweiten einstellbaren Empfangsverstärkung mittels der Empfangs-Ankopplungsschaltung (14) und des Empfangsverstärkers (16),
Berechnen einer Kreuzkorrelationsfunktion zwischen dem empfangenen realen Sendesignal und dem empfangenen Reflexionssignal mittels eines Korrelationsempfängers (18),
Bestimmen des Fehlerortes auf der elektrischen Leitung durch Auswerten der Kreuzkorrelationsfunktion mittels einer Laufzeitbetrachtung in einer Auswerteeinheit (20).

6. Schaltungsanordnung zur Durchführung eines Verfahrens zur Lokalisierung eines Fehlerortes (4) auf einer elektrischen Leitung (2) nach einem der Ansprüche 1 bis 4,
**umfassend**
einen Signalgenerator (6) zum Erzeugen einer Pseudozufalls-Impulsfolge,
eine Filtereinheit (8) zum Begrenzen eines Frequenzspektrums der Pseudozufalls-Impulsfolge,
einen Sendeverstärker (10) mit einer variabel voreinstellbaren Sendeverstärkung und eine Sende-Ankopplungsschaltung (12),
einen Empfangsverstärker (16) mit einer variabel voreinstellbaren und umschaltbaren Empfangsverstärkung und eine Empfangs-Ankopplungsschaltung (14),
einen Korrelationsempfänger (18) zum Berechnen einer Kreuzkorrelationsfunktion zwischen dem empfangenen realen Sendesignal und dem empfangenen Reflexionssignal und eine
Auswerteeinheit (20) zum Bestimmen des Fehlerortes auf der elektrischen Leitung.

7. Schaltungsanordnung nach Anspruch 6,
**dadurch gekennzeichnet,**
**dass** die Filtereinheit (8) zur Berechnung eines Fourier-Spektrums der Pseudozufalls-Impulsfolge und zur Filterung im Spektralbereich ausgeführt ist.

8. Schaltungsanordnung nach Anspruch 6,
**dadurch gekennzeichnet,**
**dass** die Filtereinheit (8) eine Tiefpass-Filterstruktur zur Filterung im Zeitbereich aufweist.

9. Schaltungsanordnung zur Durchführung eines Verfahrens zur Lokalisierung eines Fehlerortes (4) auf einer elektrischen Leitung nach Anspruch 5,
**umfassend**
einen Signalgenerator (6) zum Erzeugen eines zeitbegrenzten idealen Sendesignals aus einem harmonischen Signal mit Gauß-förmiger Hüllkurve,
einen Sendeverstärker (10) mit einer variabel voreinstellbaren und
umschaltbaren Sendeverstärkung und eine Sende-Ankopplungsschaltung (12),
einen Empfangsverstärker (16) mit einer variabel voreinstellbaren und umschaltbaren Empfangsverstärkung und eine Empfangs-Ankopplungsschaltung (14),
einen Korrelationsempfänger (18) zum Berechnen einer Kreuzkorrelationsfunktion zwischen dem empfangenen realen Sendesignal und dem empfangenen Reflexionssignal und eine
Auswerteeinheit (20) zum Bestimmen des Fehlerortes auf der elektrischen Leitung.

## Claims

1. A method for localizing a fault location (4) on an electric line (2) according to a method of time-domain reflectometry, the method having the following steps:
generating a pseudorandom pulse sequence of the length M by means of a signal generator (6),
generating an ideal transmission signal from the pseudorandom pulse sequence by limiting a frequency spectrum of the pseudorandom pulse sequence by means of a filter unit (8),
transmitting the ideal transmission signal using a variably pre-settable transmission amplification by means of a transmission amplifier (10) and a transmission connection circuit (12),
receiving and recording a real transmission signal using a first settable reception amplification while transmitting the ideal transmission signal by means of a reception connection circuit (14) and a reception amplifier (16),
switching the first settable reception amplification of the reception amplifier (16) to a second settable reception amplification of the reception amplifier (16) which is greater than the first settable reception amplification,
receiving a reflection signal using the second settable reception amplification by means of the reception connection circuit (14) and the reception amplifier (16),
computing a cross-correlation function between the received real transmission signal and the received reflection signal by means of a correlation receiver,
determining the fault location (4) on the electric line (2) by evaluating the cross-correlation function by means of a signal propagation observation in an evaluation unit (20).

2. The method according to claim 1,
**characterized in that**
the pseudorandom pulse sequence is generated from two consecutive partial sequences which are made of code sequences complementary to each other, and **in that** two consecutive correlation functions, which are computed from the respective partial sequences, are added for determining the fault location.

3. The method according to claim 1 or 2,
**characterized in that**
the frequency spectrum of the pseudorandom pulse sequence in the spectral range is limited (8) by setting to zero values of a Fourier spectrum, which are above a settable limit frequency.

4. The method according to claim 1 or 2,
**characterized in that**
the frequency spectrum of the pseudorandom pulse sequence in the time range is limited (8) by a low-pass filtering using a settable limit frequency.

5. A method for localizing a fault location (4) on an electric line (2) according to a method of time-domain reflectometry, the method having the following steps:
generating (6) a temporally limited ideal transmission signal from a harmonic signal having a Gauss-shaped envelope curve by means of a signal generator (6),
transmitting the ideal transmission signal using a variably pre-settable transmission amplification by means of a transmission amplifier (10) and a transmission coupling circuit (12),
receiving and recording a real transmission signal using a first settable reception amplification while transmitting the ideal transmission signal by means of a reception coupling circuit (14) and a reception amplifier (16),
switching the first settable reception amplification of the reception amplifier (16) to a second settable reception amplification of the reception amplifier (16) which is greater than the first settable reception amplification,
receiving a reflection signal using the second settable reception amplification by means of the reception coupling circuit (14) and the reception amplifier (16),
computing a cross-correlation function between the received real transmission signal and the received reflection signal by means of a correlation receiver (18),
determining the fault location on the electric line by evaluating the cross-correlation function by means of a propagation observation in an evaluation unit (20).

6. A circuit arrangement for carrying out a method for localizing a fault location (4) on an electric line (2) according to any one of the claims 1 to 4,
the circuit arrangement comprising
a signal generator (6) for generating a pseudorandom pulse sequence,
a filtering unit (8) for limiting a frequency spectrum of the pseudorandom pulse sequence,
a transmission amplifier (10) having a variably pre-settable transmission amplification and a transmission coupling circuit (12),
a reception amplifier (16) having a variably pre-settable and switchable reception amplification and a reception coupling circuit (14),
a correlation receiver (18) for computing a cross-correlation function between the received real transmission signal and the received reflection signal and
an evaluation unit (20) for determining the fault location on the electric line.

7. The circuit arrangement according to claim 6,
**characterized in that**
the filtering unit (8) is configured for computing a Fourier spectrum of the pseudorandom pulse sequence and for filtering in the spectral domain.

8. The circuit arrangement according to claim 6,
**characterized in that**
the filtering unit (8) comprises a low-pass filter structure for filtering in the time domain.

9. A circuit arrangement for carrying out a method for localizing a fault location (4) on an electric line according to claim 5,
the circuit arrangement comprising
a signal generator (6) for generating a temporally limited ideal transmission signal from a harmonic signal having a Gauss-shaped envelope curve,
a transmission amplifier (10) having a variably pre-settable and switchable transmission amplification and a transmission coupling circuit (12),
a reception amplifier (16) having a variably pre-settable and switchable reception amplification and a reception coupling circuit (14),
a correlation receiver (18) for computing a cross-correlation function between the received real transmission signal and the received reflection signal and
an evaluation unit (20) for determining the fault location on the electric line.

## Revendications

1. Procédé pour la localisation d'un emplacement de défaut (4) sur une ligne électrique (2) selon un procédé de la réflectométrie dans le domaine temporel, le procédé ayant les étapes suivantes :
la génération d'un train d'impulsions pseudo-aléatoire de la longueur M au moyen d'un générateur de signaux (6),
la génération d'un signal d'émission idéal à partir du train d'impulsions pseudo-aléatoire en limitant un spectre de fréquences du train d'impulsions pseudo-aléatoire au moyen d'une unité de filtrage (8),
l'émission du signal d'émission idéal en utilisant une amplification d'émission préréglable variablement au moyen d'un amplificateur d'émission (10) et un circuit (12) de connexion d'émission,
la réception et l'enregistrement d'un signal d'émission réal en utilisant une première amplification de réception réglable pendant l'émission du signal d'émission idéal au moyen d'un circuit (14) de connexion de réception et d'un amplificateur de réception (16),
la commutation de la première amplification de réception réglable de l'amplificateur de réception (16) à une deuxième amplification de réception réglable de l'amplificateur de réception (16) qui est plus grande que la première amplification de réception réglable,
la réception d'un signal de réflexion en utilisant la deuxième amplification de réception réglable au moyen du circuit (14) de connexion de réception et de l'amplificateur de réception (16),
la computation d'une fonction intercorrélation entre le signal d'émission réal reçu et le signal de réflexion reçu au moyen d'un récepteur de corrélation (18),
la détermination de l'emplacement de défaut (4) sur la ligne électrique (2) en évaluant la fonction intercorrélation au moyen d'une observation du temps de propagation de signal dans une unité d'évaluation (20).

2. Procédé selon la revendication 1,
**caractérisé en ce que**
le train d'impulsions pseudo-aléatoire est généré de deux séquences partielles consécutives qui sont formées par des séquences de code complémentaires les unes aux autres, et **en ce que** deux fonctions de corrélation consécutives, qui sont comptées à partir des séquences partielles respectives, sont additionnées pour la détermination de l'emplacement de défaut.

3. Procédé selon la revendication 1 ou la revendication 2,
**caractérisé en ce que**
le spectre de fréquences du train d'impulsions pseudo-aléatoire dans la région spectrale est limité (8) en mettant à zéro des valeurs d'un spectre de Fourier, qui sont supérieures à une fréquence limite réglable.

4. Procédé selon la revendication 1 ou la revendication 2,
**caractérisé en ce que**
le spectre de fréquences du train d'impulsions pseudo-aléatoire dans le domaine temporel est limité (8) par un filtrage passe-bas en utilisant une fréquence limite réglable.

5. Procédé pour la localisation d'un emplacement de défaut (4) sur une ligne électrique (2) selon un procédé de réflectométrie dans le domaine temporel, le procédé ayant les étapes suivantes :
la génération (6) d'un signal d'émission idéal limité temporellement à partir d'un signal harmonique ayant une courbe enveloppe gaussienne au moyen d'un générateur de signaux (6),
l'émission du signal d'émission idéal en utilisant une amplification d'émission préréglable variablement au moyen d'un amplificateur d'émission (10) et un circuit (12) de connexion d'émission,
la réception et l'enregistrement d'un signal d'émission réal en utilisant une première amplification de réception réglable pendant l'émission du signal d'émission idéal au moyen d'un circuit (14) de connexion de réception et d'un amplificateur de réception (16),
la commutation de la première amplification de réception réglable de l'amplificateur de réception (16) à une deuxième amplification de réception réglable de l'amplificateur de réception (16) qui est plus grande que la première amplification de réception réglable,
la réception d'un signal de réflexion en utilisant la deuxième amplification de réception réglable au moyen du circuit (14) de connexion de réception et de l'amplificateur de réception (16),
la computation d'une fonction intercorrélation entre le signal d'émission réal reçu et le signal de réflexion reçu au moyen d'un récepteur de corrélation (18),
la détermination de l'emplacement de défaut sur la ligne électrique en évaluant la fonction intercorrélation au moyen d'une observation du temps de propagation de signal dans une in an unité d'évaluation (20).

6. Agencement de circuit pour l'exécution d'un procédé pour la localisation d'un emplacement de défaut (4) sur une ligne électrique (2) selon l'une quelconque des revendications 1 à 4, l'agencement de circuit comprenant
un générateur de signaux (6) pour la génération d'un train d'impulsions pseudo-aléatoire,
une unité de filtrage (8) pour la limitation d'un spectre de fréquences du train d'impulsions pseudo-aléatoire,
un amplificateur d'émission (10) ayant une amplification d'émission préréglable variablement et un circuit (12) de connexion d'émission,
un amplificateur de réception (16) ayant une amplification de réception préréglable variablement et commutable et un circuit (14) de connexion de réception,
un récepteur de corrélation (18) pour la computation d'une fonction intercorrélation entre le signal d'émission réal reçu et le signal de réflexion reçu et
une unité d'évaluation (20) pour la détermination de l'emplacement de défaut sur la ligne électrique.

7. Agencement de circuit selon la revendication 6,
**caractérisé en ce que**
l'unité de filtrage (8) est configurée pour la computation d'un spectre de Fourier du train d'impulsions pseudo-aléatoire et pour le filtrage dans un domaine spectral.

8. Agencement de circuit selon la revendication 6,
**caractérisé en ce que**
l'unité de filtrage (8) comprend une structure de filtrage de passe-bas pour le filtrage dans le domaine temporel.

9. Agencement de circuit pour l'exécution d'un procédé pour la localisation d'un emplacement de défaut (4) sur une ligne électrique (2) selon la revendication 5,
l'agencement de circuit comprenant
un générateur de signaux (6) pour la génération d'un signal d'émission idéal limité temporellement à partir d'un signal harmonique ayant une courbe enveloppe gaussienne,
un amplificateur d'émission (10) ayant une amplification d'émission préréglable variablement et commutable et un circuit (12) de connexion d'émission,
un amplificateur de réception (16) ayant une amplification de réception préréglable variablement et commutable et un circuit (14) de connexion de réception,
un récepteur de corrélation (18) pour la computation d'une fonction intercorrélation entre le signal d'émission réal reçu et le signal de réflexion reçu et
une unité d'évaluation (20) pour la détermination de l'emplacement de défaut sur la ligne électrique.
